Europäisches Patentamt

European Patent Office

Office européen des brevets

(11) Veröffentlichungsnummer: **0 075 889**
A2

(12) **EUROPÄISCHE PATENTANMELDUNG**

(21) Anmeldenummer: 82108850.7

(22) Anmeldetag: 24.09.82

(51) Int. Cl.³: **C 30 B 25/02**
**C 30 B 29/06, C 30 B 25/18**

(30) Priorität: 30.09.81 DE 3138988

(43) Veröffentlichungstag der Anmeldung:
06.04.83 Patentblatt 83/14

(84) Benannte Vertragsstaaten:
AT DE FR GB IT

(71) Anmelder: SIEMENS AKTIENGESELLSCHAFT
Berlin und München Wittelsbacherplatz 2
D-8000 München 2(DE)

(72) Erfinder: Schink, Norbert, Dr., Dipl.-Chem.
Stradellastrasse 10a
D-8000 München 81(DE)

(54) Verfahren zum Herstellen dünner Siliciumschichten.

(57) Zur Herstellung preiswerter Halbleiterbauelemente wird Silicium großflächig in definierter Reinheit auf einem metallisch leitendem Trägerband abgeschieden. Das Trägerband wird kontinuierlich durch das erhitzte mit der zu zersetzenden Siliciumverbindung gefüllte Reaktionsgefäß geführt wobei eine vorher auf dem Trägerband aufgebrachte Schicht verdampft, die die flüchtige Siliciumverbindung reduziert.

FIG 1

SIEMENS AKTIENGESELLSCHAFT     Unser Zeichen

Berlin und München     —/—

### Verfahren zum Herstellen dünner Siliciumschichten

Die vorliegende Erfindung bezieht sich auf ein Verfahren und eine Anordnung zum kontinuierlichen Herstellen dünner Siliciumschichten auf einem Trägerkörper, der aus einem anderen Material als Silicium, d.h. aus einem Fremdmaterial, besteht.

Solche Produkte sind besonders geeignet zur Fertigung von scheibenförmigen Siliciumkörpern, wie sie insbesondere für Solarzellen verwendet werden.

Zur Herstellung von Solarzellen, die aus großflächigen Siliciumscheiben bestehen, soll möglichst billiges Silicium verwendet werden. Die Anforderungen, die hierbei in Bezug auf Reinheit gestellt werden, sind allerdings nicht so hoch wie bei den bei Schaltungen einsetzbaren Halbleiterbauelementen.

Es war deshalb ein Weg zu finden Silicium auf einfache und billige Weise, d.h. ohne Materialverlust, herzustellen, wobei das Silicium dennoch eine Reinheit besitzt, die auch für konventionelle Halbleiterbauelemente ausreichend ist. Außerdem sollen die teuren Arbeitsgänge wie Sägen eines Stabes und Läppen der Scheiben entfallen.

Ein Verfahren der eingangs genannten Art zum Herstellen von billigen Siliciumscheiben ist der DT-OS 25 08 369

Bar 1 Gae / 29.09.1981

zu entnehmen. Bei diesem Verfahren wird polykristallines Silicium aufgeschmolzen und durch Walzen in die Form eines die gewünschte Dicke der scheibenförmigen Siliciumkörper aufweisenden Bandes zur Erstarrung gebracht und dann dieses Band entsprechend den gewünschten Abmessungen der Siliciumkörper zerteilt. Mit Ausnahme der Zerteilung des Bandes in die einzelnen Siliciumgrundkörper fallen hier keine Säge- oder Läppprozesse an.

Es ist Aufgabe der vorliegenden Erfindung, in einem einzigen Verfahrensschritt Siliciumkörper herzustellen, die als Grundkörper für die Herstellung von Solarzellen verwendet werden können.

Diese Aufgabe wird erfindungsgemäß dadurch gelöst, daß in ein Reaktionsgefäß eine verdampfte Siliciumverbindung gebracht und ein mit einem Reduktionsmittel beschichteter Trägerkörper kontinuierlich durch das Reaktionsgefäß geführt wird, so daß sich die Siliciumverbindung zersetzt und aus dem freigesetzten Silicium eine Siliciumschicht auf dem Trägerkörper aufgetragen wird.

Die Erkenntnis, die der Erfindung zugrunde liegt, besteht darin, das für die Reduktion der verwendeten Siliciumverbindung benötigte Mittel mit dem kontinuierlich zu silicierende Träger laufend in den Reaktionsraum einzubringen. Als Trägerkörper findet dabei ein eine ebene Oberfläche aufweisender, flexibler, metallisch leitender Körper - z. B. als Band oder Folie ausgebildet - Verwendung. Er kann sowohl aus Eisen, Graphit, Titan, Molybdän oder auch aus Nickel bestehen. Der Trägerkörper besitzt erfindungsgemäß eine vorzugsweise einseitige Beschichtung mit einem die flüchtige Siliciumverbindung reduzierenden Mittel, wie Zink.

Es liegt im Rahmen der Erfindung, daß zwei mit Reduktionsmittel einseitig beschichtete Trägerkörper, deren nicht beschichtete Seiten sich berührend gegenüberliegen, in das Reaktionsgefäß eingeführt werden. Es ist auch möglich, gleichzeitig mehrere einzelne oder paarweise zusammengelegte Trägerkörper im Parallelbetrieb in das Reaktionsgefäß einzuführen.

Als Siliciumverbindung eignet sich besonders ein Siliciumhalogenid, zum Beispiel ein Siliciumbromid, insbesondere aber ein Siliciumchlorid. Unter den Siliciumchloriden sind Siliciumtetrachlorid ($SiCl_4$), und Silicochloroform ($SiHCl_3$) besonders geeignet, obwohl $SiH_2Cl_2$ und $SiH_3Cl$ nicht ausgeschlossen sind. Weniger geeignet sind reine Silane, wie $SiH_4$, das thermisch allein zerfällt und darüberhinaus noch selbstentzündlich, explosiv und giftig ist.

Die verwendete Siliciumverbindung wird entweder in seiner Dampfform oder mittels Trägergas in das Reaktionsgefäß eingeführt. Als Trägergas ist entweder Stickstoff oder ein Formiergas, z. B. ein Gasgemisch aus 15 Volumenprozent Wasserstoff und 85 Volumenprozent Stickstoff, vorgesehen.

Gemäß einer Weiterbildung der Erfindung wird das Gasgemisch mit oder ohne Trägergas kontinuierlich aus dem Reaktionsgefäß entfernt oder auch unter Abführung des Trägergases in einem hierfür vorgesehenen Kondensator auskondensiert.

Zur Durchführung des erfindungsgemäßen Verfahrens wird im Reaktionsgefäß ein Temperaturgradient eingestellt. Hierbei besitzt der Mittelbereich des Reaktionsgefäßes die Maximaltemperatur, die der Zersetzungstemperatur der verwendeten Siliciumverbindung entspricht, während an den Ein- und Ausgangsschleusen für den Trägerkörper die tiefste Reaktionsraumtemperatur herrscht. Bei Verwendung von Siliciumtetrachlorid als Siliciumverbindung und Zink als Reduktionsmittel wird dabei die Temperatur an den Schleusen nicht höher als 750° C zum Beispiel auf etwa 400° C, und im mittleren Bereich auf etwa 950° C eingestellt.

Bei Verwendung von Siliciumtetrachlorid als Siliciumverbindung wird der Verdampfer auf eine Temperatur von 40° C gebracht, während der Kondensator auf Zimmertemperatur gehalten wird.

Unter Einhaltung der zuvor beschriebenen Parameter wird der Trägerkörper mit konstanter Geschwindigkeit von etwa einem halben Meter pro Minute durch das Reaktionsgefäß bewegt.

Die Anordnung zur Durchführung des erfindungsgemäßen Verfahrens besitzt ein Reaktionsgefäß, zum Beispiel aus Quarz, mit Schleusenein- und ausgängen für den zu silicierenden Trägerkörper, wenigstens einen Einlaß für das Frischgas und wenigstens einen Auslaß für das Abgas.

Eine Heizeinrichtung ist dem Reaktionsgefäß derart zugeordnet, daß sie im Reaktionsgefäß das erforderliche Temperaturprogramm erzeugen kann. Zweckmäßigerweise besteht die Heizeinrichtung aus einem das Reaktionsgefäß umgebenden elektrisch beheizten Ofen.

Ein- und Auslaßschleusen sind im einfachsten Fall mit Glas- oder Steinwolle abgedichtet.

Die Erfindung wird anhand eines in der Figur dargestellten Ausführungsbeispiels noch näher erläutert.

Kernstück der erfindungsgemäßen Anordnung ist der zum
Beispiel aus Quarzglas bestehende Reaktor 3. Er besitzt die Eingangsschleuse 8 und die Ausgangsschleuse
9, die beide mit Glaswolle 10 abgedichtet sind. Durch
diese Schleuse wird der zu silicierende Trägerkörper 1
mit einer konstanten Geschwindigkeit von beispielsweise
einem halben Meter pro Minute mittels einer in der
Zeichnung nicht dargestellten Ziehvorrichtung in Richtung
des Pfeiles 15 hindurchbewegt.

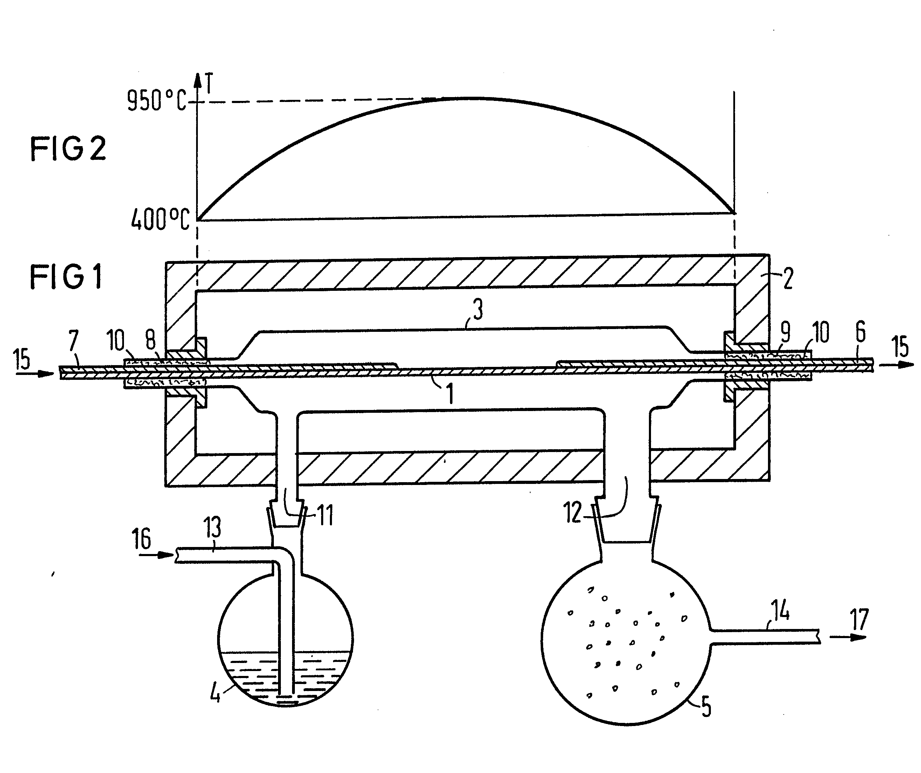

Das Reaktionsgefäß 3 wird von einem elektrisch beheizten
Stahlofen 2 umgeben, der das in der Figur 2 gezeigte
Temperaturprogramm einzustellen in der Lage ist.

Im vorliegenden Beispiel besitzt das Reaktionsgefäß einen
Gaseinlaß 11 für das Frischgas und einen Auslaß 12 für
das Abgasgemisch. Der Verdampfer 4 ist mit der zu zersetzenden Siliciumverbindung, zum Beispiel mit Siliciumtetrachlorid gefüllt und wird auf ca. $40^\circ$ C aufgeheizt.
Die Abgase werden im Kondensator 5 kondensiert, der durch
eine Wasserkühlung auf etwa $20^\circ$ C gehalten wird.

Wird mit einem Trägergas wie Stickstoff gearbeitet, so
wird es in Richtung des Pfeiles 16 über eine Zuleitung
13 in den Verdampfer 4 geführt und mit der Siliciumverbindung beladen. Der Stickstoff wird zusammen mit den
nicht kondensierten Abgasresten über die Leitung 14 in
Richtung des Pfeiles 17 wieder abgeführt.

Mit dem Verfahren gemäß vorliegender Erfindung wird
auf einem eine ebene Oberfläche aufweisenden,flexiblen

metallisch leitenden Band 1 eine polykristalline Siliciumschicht 6 abgeschieden, deren Dicke zwischen 0,01 und 0,1 mm einstellbar ist. Die Kristallkorngröße kann durch die gewählten Reaktionsbedingungen von grob- bis feinkristallin für den jeweiligen Anwendungsfall eingestellt werden.

Vom Anwendungsfall her wird auch das Material des Trägers 1 bestimmt. Im einfachsten Fall ist es Eisenblech, dieses ist billig und liefert daher billige Bauelemente. Es hat einen Schmelzpunkt, der hoch genug ist, um die Reaktionstemperaturen von etwa 950° C zu überstehen.

Für Bauelemente, bei denen es auf hohe Reinheit ankommt, d.h. bei denen die Unterlage die Halbleiterreinheit des abgeschiedenen Siliciums nach Möglichkeit nicht beeinträchtigen soll, wird entweder ein Titanband, oder aber auch ein Graphitträger vorzusehen sein.

Ein Nickelband ist immer dann vorzuziehen, wenn es bei der Weiterverarbeitung zu Halbleiter-Bauelementen auf die guten Kontaktiereigenschaften des Trägermaterials ankommt.

Bei besonders großen Bauelementen und bei solchen, die viel Strom führen müssen und daher thermisch stärker belastet werden, eignet sich als Träger ein Molybdänband, da Molybdän einen praktisch gleichen Ausdehnungskoeffizienten wie Silicium hat.

Zur Abscheidung des Siliciums aus einer Siliciumverbindung eignet sich als Reduktionsmittel besonders Zink. Dieses hat darüberhinaus noch den Vorteil, daß es sich elegant als beliebig starke Schicht 7 auf dem Trägerkörper 1, z. B. durch elektrolytische Abscheidung, aufbringen läßt. Das entstehende Reaktionsprodukt ist
leicht flüchtig und somit gut aus dem Reaktionsgefäß 3
entfernbar.

Nach der Auswahl des Trägermaterials 1 und des als
Reduktionsmittel wirkenden Beschichtungsmaterials 7 ist
die zu zersetzende Siliciumverbindung nach technischen
und ökonomischen Gesichtspunkten auszusuchen. Wird das
billigere Siliciumtetrachlorid gewählt, so empfiehlt es
sich, dieses mit einem Trägergas ins Reaktionsgefäß zu
leiten, für das sich neben Stickstoff auch ein Formiergas, wie das z. B. aus 15 Volumenprozent Wasserstoff
und 85 Volumenprozent Stickstoff bestehende Gasgemisch,
eignet. Es brennt selbst nicht und ist auch nicht explosionsgefährdet.

In dem Verdampfer 4 wird die Siliciumverbindung auf eine
Temperatur, die deutlich unter dem Siedepunkt des
Reaktionsgases liegt - bei Siliciumtetrachlorid auf etwa
$40^o$ C - erhitzt.

Das Stickstoff/Siliciumtetrachlorid-Gasgemisch gelangt
über den Gaseinlaß 11 in das Reaktionsgefäß 3 in dem
mittels des elektrisch beheizten Stahlofens 2 das in
Figur 2 dargestellte Temperaturprogramm erzeugt wird.
Die Reduktion des Siliciumtetrachlorids mit Zink läuft
bei etwa $950^o$ C ab, so daß der Reaktormittelbereich auf
diese Temperatur zu erhitzen ist.

Am Schleusenein- und -ausgang 8, 9 soll die Temperatur
nicht zu hoch gewählt werden, um die Reduktion des Gasgemisches auf einem definierten Reaktormittelbereich zu
beschränken.

Wegen des bis 732° C herab gasförmigen, als Reaktionsgemisch entstehenden Zinkchlorids ($ZnCl_2$), ist es sinnvoll, die Schleusentemperatur durch diesen Wert bestimmen zu lassen. Schleusentemperaturen von weniger
als 732° C sind möglich und zweckmäßig; in diesem Fall
wird das Zinkchlorid vom strömenden Stickstoff entsprechend seinem Partialdruck mitgenommen. Im vorliegenden Ausführungsbeispiel wurden 400° C - ein
empirisch gefundener Wert - als Schleusentemperatur
gewählt, der nicht wesentlich unterschritten werden
sollte.

Bei dem so eingestellten Temperaturprogramm wird der
einseitig verzinkte Trägerkörper 1, z. B. verzinktes
Eisenband, bis etwa 950° C dem Dampf von Siliciumtetrachlorid ausgesetzt. Dabei verdampft zuerst bei 906° C
das Zink. Der Zinkdampf reduziert dann bei 950° C das
Siliciumtetrachlorid. Das herab bis zu einer Temperatur
von 732° C gasförmige Zinkchlorid, das bei der Reaktion
entsteht, kann kontinuierlich über den Gasauslaß 12
aus dem Reaktor entfernt werden.

Im vorliegenden Ausführungsbeispiel werden die Reaktionsabgase in den Kondensator 5 geführt, wo Zinkchlorid
auskondensiert wird. Über die Leitung 14 werden Stickstoff und evtl. nicht kondensierte Abgasreste in Pfeilrichtung 17 abgeführt.

Das silicierte Eisenband 1, 6 kann hinter dem Reaktor
- evtl. nach Anritzen der Siliciumschicht - aufgewickelt werden.

Patentansprüche

1. Verfahren zum kontinuierlichen Herstellen dünner Siliciumschichten auf einem aus einem anderen Material bestehenden Trägerkörper, d a d u r c h   g e k e n n -
z e i c h n e t,   daß in ein Reaktionsgefäß eine verdampfte Siliciumverbihdung gebracht und ein mit einem
Reduktionsmittel beschichteter Trägerkörper kontinuierlich durch das Reaktionsgefäß geführt wird, so daß sich
die Siliciumverbindung zersetzt und aus dem freiwerdenden Silicium eine Siliciumschicht auf dem Trägerkörper
aufgetragen wird.

2. Verfahren nach Anspruch 1, d a d u r c h   g e -
k e n n z e i c h n e t,   daß als Trägerkörper ein eine ebene Oberfläche aufweisender, flexibler, metallisch
leitender Körper, z. B. als Band oder Folie ausgebildet,
Verwendung findet.

3. Verfahren nach Anspruch 1 und 2, d a d u r c h
g e k e n n z e i c h n e t,   daß der Trägerkörper aus
Eisen besteht.

4. Verfahren nach Anspruch 1 und 2, d a d u r c h
g e k e n n z e i c h n e t,   daß der Trägerkörper aus
Graphit besteht.

5. Verfahren nach Anspruch 1 und 2, d a d u r c h
g e k e n n z e i c h n e t,   daß der Trägerkörper aus
Titan besteht.

6. Verfahren nach Anspruch 1 und 2, d a d u r c h
g e k e n n z e i c h n e t,   daß der Trägerkörper aus
Molybdän besteht.

7. Verfahren nach Anspruch 1 und 2, d a d u r c h g e k e n n z e i c h n e t, daß der Trägerkörper aus Nickel besteht.

8. Verfahren nach wenigstens einem der Ansprüche 1 bis 7, d a d u r c h  g e k e n n z e i c h n e t, daß der Trägerkörper eine vorzugsweise einseitige Beschichtung mit einem die flühtige Siliciumverbindung reduzierenden Mittel aufweist.

9. Verfahren nach wenigstens einem der Ansprüche 1 bis 8, d a d u r c h  g e k e n n z e i c h n e t, daß als Reduktionsmittel Zink vorgesehen ist.

10. Verfahren nach wenigstens einem der Ansprüche 1 bis 9, d a d u r c h  g e k e n n z e i c h n e t, daß zwei mit dem Reduktionsmittel einseitig beschichtete Trägerkörper, deren nicht beschichtete Seiten sich berührend gegenüberliegen, in das Reaktionsgefäß eingeführt werden.

11. Verfahren nach wenigstens einem der Ansprüche 1 bis 10, d a d u r c h  g e k e n n z e i c h n e t, daß gleichzeitig mehrere Trägerkörper im Parallelbetrieb in das Reaktionsgefäß eingeführt werden.

12. Verfahren nach wenigstens einem der Ansprüche 1 bis 11, d a d u r c h  g e k e n n z e i c h n e t, daß als Siliciumverbindung ein Siliciumhalogenid, vorzugsweise Siliciumchlorid, vorgesehen ist.

13. Verfahren nach wenigstens einem der Ansprüche 1 bis 12, d a d u r c h  g e k e n n z e i c h n e t, daß als Siliciumchlorid Siliciumtetrachlorid ($SiCl_4$) oder Silicochloroform ($SiHCl_3$) verwendet wird.

14. Verfahren nach wenigstens einem der Ansprüche 1 bis

13, d a d u r c h g e k e n n z e i c h n e t, daß die verwendete Siliciumverbindung in Dampfform in das Reaktionsgefäß eingeführt wird.

15. Verfahren nach wenigstens einem der Ansprüche 1 bis 14, d a d u r c h g e k e n n z e i c hn e t, daß die Siliciumverbindung mittels eines Trägergases in das Reaktionsgefäß eingeführt wird.

16. Verfahren nach wenigstens einem der Ansprüche 1 bis 15, d a d u r c h g e k e n n z e i c h n e t, daß als Trägergas Stickstoff vorgesehen ist.

17. Verfahren nach wenigstens einem der Ansprüche 1 bis 15, d a d u r c h g e k e n n z ei c h n e t, daß als Trägergas ein Formiergas vorgesehen ist.

18. Verfahren nach Anspruch 17, d a d u r c h g e - k e n n z e i c h n e t, daß das Formiergas aus einem Gasgemisch von 15 Volumenprozent Wasserstoff und 85 Volumenprozent Stickstoff besteht.

19. Verfahren nach wenigstens einem der Ansprüche 1 bis 18, d a d u r c h g e k e n n z e i c h n e t, daß die Reaktionsabgase kontinuierlich aus dem Reaktionsgefäß entfernt werden.

20. Verfahren nach wenigstens einem der Ansprüche 1 bis 19, d a d u r c h g e k e n n z e i c h n e t, daß die Reaktionsabgase auskondensiert werden.

21. Verfahren nach wenigstens einem der Ansprüche 1 bis 20, d a d u r c h g e k e n n z e i c h n e t, daß im Reaktionsgefäß ein Temperaturgradient eingestellt und aufrecht erhalten wird.

22. Verfahren nach wenigstens einem der Ansprüche 1 bis 21, d a d u r c h   g e k e n n z e i c h n e t, daß der Mittelbereich des Reaktionsgefäßes die Maximaltemperatur besitzt.

23. Verfahren nach wenigstens einem der Ansprüche 1 bis 22, d a d u r c h   g e k e n n z e i c h n e t, daß die Maximaltemperatur der Zersetzungstemperatur der verwendeten Siliciumverbindung entspricht.

24. Verfahren nach wenigstens einem der Ansprüche 1 bis 21, d a d u r c h   g e k e n n z e i c h n e t, daß im Bereich der Ein- und Ausgangsschleusen für den Trägerkörper die tiefste Reaktionsraumtemperatur eingestellt wird.

25. Verfahren nach wenigstens einem der Ansprüche 1 bis 24, d a d u r c h   g e k e n n z e i c h n e t, daß bei Verwendung von Siliciumchlorid als Siliciumverbindung und Zink als Reduktionsmittel die Temperatur an den Schleusen höchstens auf 750°C, z. B. auf etwa 400°C, und die Maximaltemperatur auf etwa 950°C eingestellt wird.

26. Verfahren nach wenigstens einem der Ansprüche 1 bis 25, d a d u r c h   g e k e n n z e i c h n e t, daß bei Verwendung von Siliciumtetrachlorid als Siliciumverbindung der Verdampfer auf eine Temperatur von 40°C gebracht wird.

27. Verfahren nach wenigstens einem der Ansprüche 1 bis 26, d a d u r c h   g e k e n n z e i c h n e t, daß der Kondensator auf Zimmertemperatur gehalten wird.

28. Verfahren nach wenigstens einem der Ansprüche 1 bis 27, d a d u r c h   g e k e n n z e i c h n e t, daß der Trägerkörper mit konstanter Geschwindigkeit, von z. B.

1/2 Meter pro Minute, durch das Reaktionsgefäß bewegt wird.

29. Anordnung zur Durchführung des Verfahrens nach Anspruch 1 bis 28, d a d u r c h  g e k e n n z e i c h n e t , daß ein Reaktionsgefäß vorgesehen ist, das Schleusenein- und -ausgänge für den/zu silicierenden Trägerkörper, wenigstens einen Einlaß für das Frischgas und wenigstens einen Auslaß für das Abgas besitzt, und daß eine Heizeinrichtung dem Raktionsgefäß derart zugeordnet ist, daß sie im Reaktionsgefäß das erforderliche Temperaturprogramm erzeugt.

30. Anordnung nach Anspruch 29, d a d u r c h  g e - k e n n z e i c h n e t ,  daß das Reaktionsgefäß aus Quarz besteht.

31. Anordnung nach Anspruch 29 und 30, d a d u r c h  g e k e n n z e i c h n e t ,  daß als Heizeinrichtung ein elektrisch beheizter, das Reaktionsgefäß umgebender Ofen Verwendung findet.

32. Anordnung nach Anspruch 29 bis 31, d a d u r c h  g e k e n n z e i c h n e t ,  daß die Ein- und Auslaßschleusen mit Glaswolle abgedichtet sind.

33. Anordnung nach Anspruch 29 bis 31, d a d u r c h  g e k e n n z e i c h n e t ,  daß die Ein- und Auslaßschleusen mit Steinwolle abgedichtet sind.

FIG 2

FIG 1

950°C

400°C